# EUROPEAN PATENT SPECIFICATION

(11) **EP 4 293 373 B1**
(45) Date of publication and mention of the grant of the patent: **18.03.2026**
(21) Application number: 23156495.6
(22) Date of filing: 14.02.2023
(51) Int. Cl.: G01R 31/367, G01R 31/392

(54) **METHOD AND APPARATUS WITH BATTERY SHORT DETECTION**
VERFAHREN UND VORRICHTUNG MIT BATTERIEKURZSCHLUSSERKENNUNG
PROCÉDÉ ET APPAREIL DE DÉTECTION DE COURT-CIRCUIT DE BATTERIE

(30) Priority: 13.06.2022 KR 20220071689
(43) Date of publication of application: 20.12.2023
(73) Proprietor: Samsung Electronics Co., Ltd., Suwon-si, Gyeonggi-do 16677 (KR)
(72) Inventor: Lee, Myeongjae, Suwon-si, Gyeonggi-do 16678 (KR); Kim, Jinho, Suwon-si, Gyeonggi-do 16678 (KR); Song, Tae Won, Suwon-si, Gyeonggi-do 16678 (KR); Huang, Terrance Christopher, Suwon-si, Gyeonggi-do 16678 (KR)
(74) Representative: Kuhnen & Wacker Patent- und Rechtsanwaltsbüro PartG mbB

(56) References cited:
- EP-A1- 3 550 317
- CN-A- 112 363 059
- CN-A- 113 253 120
- US-A1- 2020 355 749

## Description

### BACKGROUND

### 1. Field

The following description relates to a method and apparatus with battery short detection.

### 2. Description of Related Art

A battery short circuit deteriorates battery efficiency and can cause thermal runaway. Thus, it can be beneficial to detect a short circuit in a battery before the short circuit causes an increase in physical and thermal deformation of the battery. In general, short circuit detection methods have used a change in current, voltage, capacity, temperature, or the like, or have used a change in various parameters of an electric circuit model. In addition, to detect a short in a multi-cell battery pack, there is a method of using various deviation values between unit cells constituting a multi-cell.

EP 3 550 317 A1 relates to a method and device for detecting battery micro-short circuit. The method includes obtaining a target initial battery parameter value of a target battery at an initial moment, and determining a reference initial battery parameter value of a virtual reference battery at the initial moment, where a response of the virtual reference battery is the same as a response of the target battery when a same excitation condition is given; obtaining a target battery parameter value of the target battery at a specified moment; determining a reference battery parameter value of the virtual reference battery at the specified moment based on the target battery parameter value and the reference initial battery parameter; and calculating a difference between the target battery parameter value and the reference battery parameter value, and determining, based on the difference, that the target battery is micro-short-circuited.

CN 113 253 120 A relates to a battery sudden internal short circuit diagnosis method and device, storage medium and electronic equipment. This technique relates to a battery sudden internal short circuit diagnosis method and device, a storage medium and electronic equipment, and belongs to the field of batteries.

US 2020/355749 A1 relates to a device detecting abnormality of secondary battery, abnormality detection method, and program. A secondary battery control system conducts abnormality detection while predicting other parameters such as internal resistance, SOC, and the like, wherein a difference between an observation value (voltage) at a certain point in time and a voltage that is estimated using a prior-state variable is sensed.

CN 112 363 059 A relates to a battery fault diagnosis method and system. This technique provides a battery fault diagnosis method and system. The method and system built a voltage prediction model based on a gray system theory according to fluctuation characteristics of a voltage during the charging and discharging of a battery.

### SUMMARY

This Summary is provided to introduce a selection of concepts in a simplified form that are further described below in the Detailed Description. This Summary is not intended to identify key features or essential features of the claimed subject matter, nor is it intended to be used as an aid in determining the scope of the claimed subject matter.

The invention is defined by the independent claims. Preferred embodiments are specified in the dependent claims.

According to an aspect of the present invention, a short circuit detecting method includes determining measurement data by measuring a battery for a target timespan including a battery charging timespan and a battery discharging timespan, determining estimation data of the battery for the target timespan using a battery model that simulates the battery to determine the estimation data, determining a resistance error parameter of the battery based on the measurement data and the estimation data, and determining that a battery short circuit condition is satisfied based on a result of comparing the resistance error parameter and a short circuit threshold value.

The measurement data may include a measured voltage and a measured current, the estimation data may include an estimated voltage, the resistance error parameter may be determined based on a ratio between a voltage error and the measured current, and the voltage error may correspond to a difference between the measured voltage and the estimated voltage.

The resistance error parameter includes a first sub-parameter representing a difference between a first average resistance error in a first sub-timespan of the discharging timespan and a second average resistance error in a second sub-timespan of the charging timespan, and may further include a second sub-parameter representing a rate of change in a resistance error in a third sub-timespan of the discharging timespan, and a third sub-parameter representing a rate of change in a resistance error in a fourth sub-timespan of the charging timespan.

The measurement data may include battery measurement values of a preset detection interval, the estimation data may include battery estimation values of the preset detection interval, resistance error values of the preset detection interval may be determined based on the measurement values and the estimation values, and the resistance error parameter may correspond to an operation result obtained based on the resistance error values.

The determining the resistance error parameter may include determining the first average resistance error based on an average of the resistance error values in the first sub-timespan, determining the second average resistance error based on an average of the resistance error values in the second sub-timespan, and determining the first sub-parameter based on a difference between the first average resistance error and the second average resistance error.

The determining the resistance error parameter may include determining the second sub-parameter based on a rate of increase in an error of the resistance error values in the third sub-timespan.

The determining the resistance error parameter may include determining the third sub-parameter based on a rate of decrease in an error of the resistance error values in the fourth sub-timespan.

The resistance error parameter may include sub-parameters having different degrees of short-detection sensitivity, and different remediation operations may be performed in accordance with the degrees of short-detection sensitivity.

The determining that the battery short circuit condition is satisfied may include determining an internal resistance of the battery based on an estimated voltage of the estimation data and a measured current of the measurement data, determining an error ratio based on a ratio between the internal resistance and the resistance error parameter, determining a short circuit current based on a multiplication of the measured current and the error ratio, and determining a short circuit resistance of the short circuit based on a ratio between the estimated voltage and the short circuit current.

An entry condition for a short circuit detection mode may include a charging/discharging temperature, a charging/discharging range, and/or a charging/discharging speed, and the determining the measurement data, the determining the estimation data, the determining the resistance error parameter, and the determining that a battery short circuit condition may be satisfied may be performed based on satisfaction of the entry condition.

The short circuit threshold value may be determined based on a preliminary experimental result, may be determined based on an actual driving result during an initial driving section of the battery, or may be determined by adjusting an existing experimental result to the actual driving result.

A non-transitory computer-readable storage medium may store instructions that, when executed by a processor, cause the processor to perform the method.

According to another aspect of the present invention, a short circuit detection apparatus includes one or more processors, and a memory storing instructions configured to, when executed by the one or more processors, cause the one or more processors to determine measurement data by measuring a battery in a target timespan may further include at least a charging timespan of charging the battery and a discharging timespan of discharging the battery, determine estimation data of the battery for the target timespan using a battery model that simulates the battery, determine a resistance error parameter of the battery based on an error between the measurement data and the estimation data, and detect a short circuit of the battery based on a result of comparison between the resistance error parameter and a short circuit threshold value.

The measurement data may include a measured voltage and a measured current, the estimation data may include an estimated voltage, the resistance error parameter may be determined based on a ratio between a voltage error and the measured current, and the voltage error may correspond to a difference between the measured voltage and the estimated voltage.

The resistance error parameter includes a first sub-parameter representing a difference between a first average resistance error in a first sub-timespan of the discharging timespan and a second average resistance error in a second sub-timespan of the charging timespan, and may further include a second sub-parameter representing a rate of change in a resistance error in a third sub-timespan of the discharging timespan, and a third sub-parameter representing a rate of change in a resistance error in a fourth sub-timespan of the charging timespan.

The resistance error parameter may include sub-parameters having different degrees of detection sensitivity to a short circuit of the battery, and different remediation operations may be performed in accordance with the degrees of detection sensitivity.

The instructions may be further configured to cause the one or more processors to determine an internal resistance of the battery based on an estimated voltage of the estimation data and a measured current of the measurement data, determine an error ratio based on a ratio between the internal resistance and the resistance error parameter, determine a short circuit current based on a multiplication of the measured current and the error ratio, and determine a short circuit resistance based on a ratio between the estimated voltage and the short circuit current.
According to still a further aspect of the present invention, a non-transitory computer-readable storage medium storing instructions that, when executed by one or more processors of an apparatus comprising a battery configured to supply power to the apparatus, cause the one or more processors to: measure measurement data of a battery for a timespan during which the battery is being charged and is being discharged; estimate estimation data of the battery based on an output of a battery model that simulates the battery; determine a resistance error parameter of the battery based on the measurement data and the estimation data; and detect a short circuit of the battery based the resistance error parameter and a short circuit threshold value, wherein the resistance error parameter comprises a first sub-parameter representing a difference between a first average resistance error in a first sub-timespan during which the battery is discharged and a second average resistance error in a second sub-timespan during which the battery is charged.

The measurement data may include a measured voltage and a measured current, the estimation data may include an estimated voltage, and the resistance error parameter may be determined based on a ratio between a voltage error and the measured current, the voltage error corresponding to a difference between the measured voltage and the estimated voltage.

Estimation data may be provided by the model based on the measurement data, and wherein the short circuit may be detected based on evaluating the resistance error parameter against a short circuit threshold value.

Other features and aspects will be apparent from the following detailed description, the drawings, and the claims.

### BRIEF DESCRIPTION OF THE DRAWINGS

FIG. 1 illustrates an example configuration of a short circuit detection apparatus, according to one or more embodiments.
FIG. 2 illustrates an example of deriving short circuit error parameters, according to one or more embodiments.
FIG. 3 illustrates an example of deriving short circuit error parameters, according to one or more embodiments.
FIG. 4 illustrates an example of short circuit detection operations, according to one or more embodiments.
FIG. 5 illustrates an example of using sub-parameters of short circuit error parameters, according to one or more embodiments.
FIG. 6 illustrates an example of a data difference between a normal cell and a micro-short circuit cell, according to one or more embodiments.
FIG. 7 illustrates an example of deriving a short circuit resistance, according to one or more embodiments.
FIG. 8 illustrates an example configuration of a short circuit detection apparatus, according to one or more embodiments.
FIG. 9 illustrates an example configuration of an electronic apparatus, according to one or more embodiments.
FIG. 10 illustrates an example of a short circuit detection method, according to one or more embodiments.

Throughout the drawings and the detailed description, unless otherwise described or provided, the same or like drawing reference numerals will be understood to refer to the same or like elements, features, and structures. The drawings may not be to scale, and the relative size, proportions, and depiction of elements in the drawings may be exaggerated for clarity, illustration, and convenience.

### DETAILED DESCRIPTION

The following detailed description is provided to assist the reader in gaining a comprehensive understanding of the methods, apparatuses, and/or systems described herein. However, various changes, modifications, and equivalents of the methods, apparatuses, and/or systems described herein will be apparent after an understanding of the disclosure of this application. For example, the sequences of operations described herein are merely examples, and are not limited to those set forth herein, but may be changed as will be apparent after an understanding of the disclosure of this application, with the exception of operations necessarily occurring in a certain order. Also, descriptions of features that are known after an understanding of the disclosure of this application may be omitted for increased clarity and conciseness.

The features described herein may be embodied in different forms and are not to be construed as being limited to the examples described herein. Rather, the examples described herein have been provided merely to illustrate some of the many possible ways of implementing the methods, apparatuses, and/or systems described herein that will be apparent after an understanding of the disclosure of this application.

The terminology used herein is for describing various examples only and is not to be used to limit the disclosure. The articles "a," "an," and "the" are intended to include the plural forms as well, unless the context clearly indicates otherwise. As used herein, the term "and/or" includes any one and any combination of any two or more of the associated listed items. As non-limiting examples, terms "comprise" or "comprises," "include" or "includes," and "have" or "has" specify the presence of stated features, numbers, operations, members, elements, and/or combinations thereof, but do not preclude the presence or addition of one or more other features, numbers, operations, members, elements, and/or combinations thereof.

Throughout the specification, when a component or element is described as being "connected to," "coupled to," or "joined to" another component or element, it may be directly "connected to," "coupled to," or "joined to" the other component or element, or there may reasonably be one or more other components or elements intervening therebetween. When a component or element is described as being "directly connected to," "directly coupled to," or "directly joined to" another component or element, there can be no other elements intervening therebetween. Likewise, expressions, for example, "between" and "immediately between" and "adjacent to" and "immediately adjacent to" may also be construed as described in the foregoing.

Although terms such as "first," "second," and "third", or A, B, (a), (b), and the like may be used herein to describe various members, components, regions, layers, or sections, these members, components, regions, layers, or sections are not to be limited by these terms. Each of these terminologies is not used to define an essence, order, or sequence of corresponding members, components, regions, layers, or sections, for example, but used merely to distinguish the corresponding members, components, regions, layers, or sections from other members, components, regions, layers, or sections. Thus, a first member, component, region, layer, or section referred to in the examples described herein may also be referred to as a second member, component, region, layer, or section without departing from the teachings of the examples.

Unless otherwise defined, all terms, including technical and scientific terms, used herein have the same meaning as commonly understood by one of ordinary skill in the art to which this disclosure pertains and based on an understanding of the disclosure of the present application. Terms, such as those defined in commonly used dictionaries, are to be interpreted as having a meaning that is consistent with their meaning in the context of the relevant art and the disclosure of the present application and are not to be interpreted in an idealized or overly formal sense unless expressly so defined herein. The use of the term "may" herein with respect to an example or embodiment, e.g., as to what an example or embodiment may include or implement, means that at least one example or embodiment exists where such a feature is included or implemented, while all examples are not limited thereto.

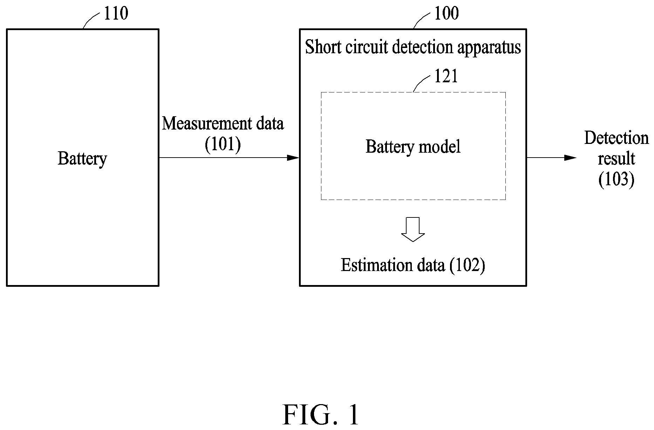

FIG. 1 illustrates an example configuration of a short circuit detection apparatus, according to the present invention. Note that term "short circuit detection apparatus" and the like, as used herein, does not imply a monolithic or single configuration, rather, this phrase is for convenience and refers to various apparatus configurations as described herein. A battery short circuit may deteriorate energy efficiency of a battery and may cause a serious safety problem. For example, a battery short circuit may cause thermal runaway of a battery. For safety, it can be helpful to detect a battery short circuit at a micro-short circuit level, as early detection can allow safety measures may be carried out. When a battery has a micro-short circuit, the short may cause only a small change in a battery signal or operation parameter (for example, a current, a voltage, and a temperature), which can make short detection difficult. In addition, it is difficult to detect a current effect (e.g., a deviation from normal) of a micro-short circuit while charging the battery because such a current effect may be extremely small compared to a charging current. Therefore, in the related art, short detection has focused on detecting larger (non-micro) short circuits, or detecting a short circuit in a battery rest state, which makes it difficult to detect a short circuit by effectively isolating it from a change in battery state (e.g., a driving temperature, a battery deterioration, or the like) that may occur during battery driving (when the battery is not at rest).

Although a battery short circuit may be determined by learning a difference or change in parameters through artificial intelligence (AI) technologies such as machine learning, the degree and accuracy of detectable short circuits may significantly vary depending on the accuracy of a model, and micro-short circuit detection may be limited according to high-rate driving, a deterioration, a measurement error, or the like. In addition, required computing power may increase due to use of AI technology. Nonetheless, some operations described herein may nonetheless be performed using AI techniques, for example, a battery model may be implemented with a neural network model.

Referring to FIG. 1, a short circuit detection apparatus 100 may output a detection result 103 of detecting a battery short circuit based on measurement data 101. The measurement data 101 may include data related to specification and/or an operation of a battery 110 monitored by the short circuit detection apparatus 100. The measurement data 101 includes a battery signal while a battery 110 is charging, or the measurement data 101 may include a battery signal while the battery 110 is discharging. For example, the battery signal may include a voltage, a current, and/or a temperature of a battery. The measurement data 101 may be measured by various sensors inside and/or outside the battery. The detection result 103 may include short circuit information indicating whether a short circuit is detected (or predicted), detection time of when the short circuit began, a duration of the short circuit, and/or an intensity of the short circuit. According to the detection result 103, a remediation operation for the short circuit may be performed.

The short circuit detection apparatus 100 estimates a state of the battery 110 (e.g., a state of charge (SOC), a voltage, or the like) using a battery model 121 simulating (modeling) the battery 110 to determine estimation data 102. According to some embodiments, the battery model 121 may be an electrochemical thermal (ECT) model. The ECT model may simulate an internal state of the battery using various ECT parameters and governing equations. For example, the parameters of the ECT model may indicate a shape or other geometric feature (for example, thickness, radius), an open circuit potential (OCP), and physical properties (for example, electrical conductivity, ionic conductivity, and diffusion coefficient). The governing equations of the ECT model may include equation(s) of an electrochemical reaction occurring between an electrode and an interface of an electrolyte based on these parameters, and a physical conservation equation associated with the electrode and a conservation of a concentration of the electrolyte and electrical charges.

According to some embodiments, an ECT model may estimate a state of the battery 110 based on the measurement data 101. For example, the ECT model may estimate an SOC and a voltage of the battery 110 based on a current and temperature of the battery 110 (e.g., from the measurement data 101). The short circuit detection apparatus 100 may detect a short circuit state by using an error (e.g., discrepancy) between the measurement data 101 measured from the battery 110 and the estimation data 102 estimated by the battery model 121 ("detect" refers to estimating or predicting a short circuit, for example by determining that a condition exists that is strongly correlated with a short circuit). The error may be referred to as an estimation error. The battery model 121 may further include an error correction model that corrects the estimation data 102 to reduce the estimation error. For example, the error correction model may correct a voltage estimation value and/or an SOC estimation value such that a voltage estimation error between a voltage measurement value and a voltage estimation value is reduced. As the error increases, the correction value may increase. The short circuit detection apparatus 100 may use a change in the correction value and/or a change in the error during a time period for short circuit detection.

According to the present invention, the short circuit detection apparatus 100 determines a resistance error parameter of the battery 110 based on an error between the measurement data 101 and the estimation data 102, and detect a short circuit of the battery 110 based on a result of a comparison between the resistance error parameter and a short circuit threshold value. More specifically, the short circuit detection apparatus 100 may measure a value (e.g., voltage) of the battery 110, estimate a value (e.g., voltage) of the battery 110 in a normal state, and derive a difference between a measured value (e.g., voltage) and an estimated value (e.g., voltage). At the time of estimating a voltage of the battery 110 in an assumed/modeled normal state, when a change in an actual state of the battery 110 (such as a deterioration state, which deviates from the model) is applied to the estimated voltage, such a difference may correspond to (be predictive of) a short circuit component of the measured value. The short circuit component herein may be expressed as a product of a short circuit resistance and a short circuit current. The short circuit detection apparatus 100 may use a resistance error parameter to perform short circuit detection based on a relationship showing that a difference between a measured voltage and an estimated voltage corresponds to a short circuit component.

According to some embodiments, the measurement data 101 may include a measured voltage and a measured current of the battery 110, and the estimation data 102 may include an estimated voltage of the battery 110. The short circuit detection apparatus 100 may determine the resistance error parameter based on a ratio between a voltage error and a measured current, where the voltage error corresponds to a difference between a measured voltage and an estimated voltage. According to some embodiments, the measurement data 101 may include measured values (e.g., voltage, current) of the battery at respective preset detection periods (intervals), and the estimation data 102 may include corresponding estimated values of the battery (e.g., of voltage) at the respective preset detection periods (intervals). The short circuit detection apparatus 100 may determine resistance error values of the respective preset detection periods/intervals based on the respective measured values and the estimated values, and may determine a resistance error parameter by performing an operation based on the determined resistance error values. For example, the resistance error parameter may be determined according to characteristics of the resistance error values, for example, an average, a cumulative value, a rate of change, and/or the like. Such analysis may be divided into time sub-sections (sub-sequences of the resistance error values). For example, (with "section" and "sub-section" referring to various timespans) the resistance error parameter may include one or more of (1) a first sub-parameter representing a difference between (i) a first average resistance error of resistance error values in a first sub-section in a discharging section and (ii) a second average resistance error of resistance error values in a second sub-section in a charging section, (2) a second sub-parameter representing a rate of change in resistance error values in a third sub-section (timespan) in the discharging section, and (3) a third sub-parameter representing a rate of change in resistance error values of resistance error values in a fourth sub-section in the charging section.

The short circuit detection apparatus 100 may determine a resistance error parameter by using the measurement data 101 measured from a unit cell and multi-cell of the battery and the battery model 121, and distinguish a normal state and a short circuit state of a battery cell using the resistance error parameter. According to an example embodiment, the short circuit detection apparatus 100 may indicate a short circuit in stepwise manner by using sub-parameters of the resistance error parameter. According to an example embodiment, the short circuit detection apparatus 100 may increase the accuracy of short circuit determination and calculate a short circuit current (i.e., a computed current value that can be compared to measured current to detect a short) and/or a short circuit resistance (i.e., a computed value that can be compared to a measured resistance to detect a short) in a battery usage conditions that include a fast smartphone charging condition, for example.

As noted, a change in a measured battery signal (a current, a voltage, and a temperature) due to a micro-short circuit can be significantly small, in particular, in comparison with a change in a measured battery signal due to other changing conditions such as an actual charging/discharging speed, a charging/discharging range (e.g., a voltage range, a time period, or a speed range), a temperature, a difference between batteries, a battery deterioration, etc. Since such non-short-driven signal changes may appear to be greater than a short-driven signal change, it may be difficult to detect a short circuit and calculate an internal short circuit resistance of the battery 110 during driving of the battery. The short circuit detection device 100 may (i) use the high-accuracy battery model 121 having a parameter updating function (for updating the model according to deterioration progress) and/or an SOC correction function, (ii) select resistance error parameters, and (iii) announce (e.g., generate a signal, notification, etc.) a battery short circuit in a stepwise manner. The short circuit detection device 100 may thereby, while the battery is actually driving (e.g., not resting), increase the probability of distinguishing a short circuit state from a normal state and reduce the probability of false detection. Herein, the SOC correction function may correspond to a function of maintaining an estimation accuracy by correcting an SOC state at a certain ratio when there is a state estimation error of the battery model 110. The parameter updating function according to deterioration progress may correspond to a function of updating a parameter of the battery model 121, such as a deterioration parameter, to an accurate value through the estimation of the deterioration state and maintaining a state estimation accuracy of the battery model 121, even when the battery deteriorates normally.

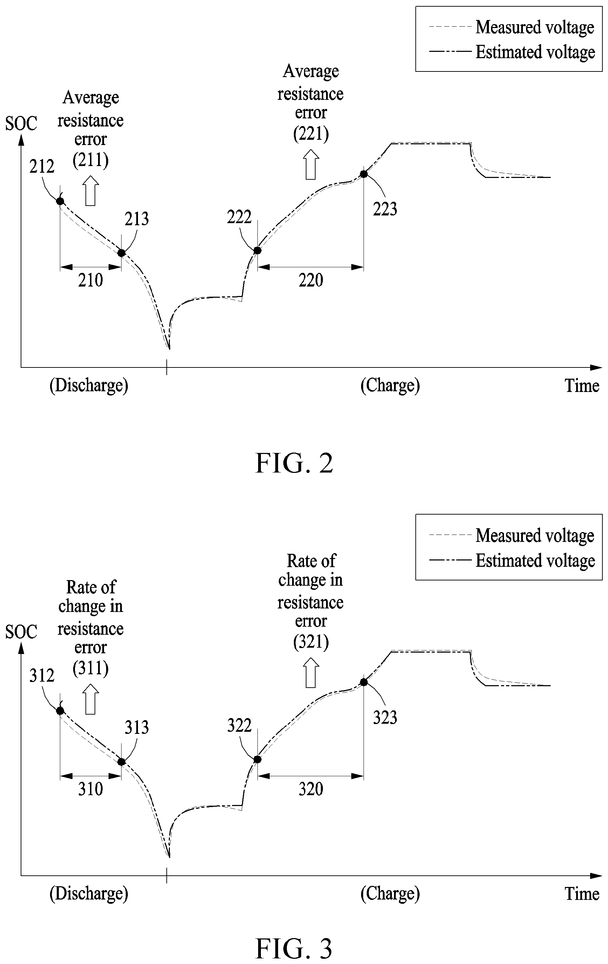

FIGS. 2 and 3 illustrate examples of deriving short circuit error parameters, according to one or more embodiments. Note that the vertical hashes on the "time" axes of FIGS. 2 and 3 indicate a time when switching from discharging to charging. Referring to FIG. 2, the short circuit detection apparatus is configured to set a first sub-section 210 (sub-timespan) of a discharging section of the battery and a second sub-section 220 of a charging section of the battery as respective target sections (target timespans), determine a first average resistance error 211 in the first sub-section 210 and a second average resistance error 221 in the second sub-section 220, and determine a sub-parameter representing a difference between the first average resistance error 211 and the second average resistance error 221. This sub-parameter is referred to as a first sub-parameter. The resistance error parameter may then be determined based on at least one sub-parameter (including at least the first sub-parameter) of the resistance error parameter.

The short circuit detection apparatus may determine the first and second average resistance errors 211 and 221 from the measurement data and the estimation data. The measurement data may include measured voltage values and measured current values of a detection period, and the estimation data may include estimated voltage values of the detection period (interval). The detection period may be set in advance. For example, the detection period may be 1/4 of a second. However, this is merely an example, and the detection period may be set to various values. The short circuit detection apparatus may determine a resistance error value by, per Ohm's Law, dividing a voltage error (corresponding to a difference between the measured voltage value and the estimated voltage value of each detection period) by the measured current value. The short circuit detection apparatus may determine resistance error values in the target sections according to the detection period, determine the first average resistance error 211 based on an average of the resistance error values in the first sub-section 210, determine the second average resistance error 221 based on an average of the resistance error values in the second sub-section 220, and determine the first sub-parameter based on the difference between the first average resistance error 211 and the second average resistance error 221.

According to an example embodiment, the short circuit detection apparatus may set a target section based on an SOC level. For example, the short circuit detection apparatus may set the first sub-section 210 (a discharging section) as a time from a first SOC level 212 to a second SOC level 213. The apparatus may set the second sub-section 220 (a charging section) as a time from a third SOC level 222 to a fourth SOC level 223. The first SOC level 212 and the fourth SOC level 223, and/or the second SOC level 213 and the third SOC level 222, may be set to be the same as each other or to be different from each other. In addition, an interval between the first SOC level 212 and the second SOC level 213 may be set to be the same as or to be different from an interval between the third SOC level 222 and the fourth SOC level 223. For example, for an interval of 50%, the first SOC level 212 may be 100%, the second SOC level 213 may be 50%, the third SOC level 222 may be 25%, and the fourth SOC level 223 may be 75%.

Referring to FIG. 3, the short circuit detection apparatus may set a third sub-section 310 in the discharging section of the battery as a target section and determine a sub-parameter representing a first rate of change 311 in the resistance error in the third sub-section 310. This sub-parameter may be referred to as a second sub-parameter. The short circuit detection apparatus may set a fourth sub-section 320 in the charging section of the battery as a target section and determine a sub-parameter representing a second rate of change 321 in the resistance error in the fourth sub-section 320. This sub-parameter may be referred to as a third sub-parameter. The short circuit detection apparatus may determine the resistance error values in the target sections according to the detection period (sampling interval), determine the third sub-parameter based on the rate of change in the resistance error values in the third sub-section 310, and determine the fourth sub-parameter based on the rate of change in the resistance error values in the fourth sub-section 320.

The short circuit detection apparatus may determine the second sub-parameter based on a rate of increase in the resistance error values in the third sub-section 310 and determine the third sub-parameter based on a rate of decrease in the resistance error values in the fourth sub-section 320. The short circuit detection apparatus may determine the second sub-parameter and/or the third sub-parameter according to the rate of change during the preset number of detection periods. For example, the second sub-parameter and/or the third sub-parameter may be determined according to the rate of change during one detection period or the rate of change during four detection periods. However, this is merely an example and the number of detection periods in which the rate of change is measured may vary.

According to some embodiments, the short circuit detection apparatus may set a target section based on SOC levels. For example, the short circuit detection apparatus may set a section, in which discharging from a fifth SOC level 312 to a sixth SOC level 313 is made, as the third sub-section 310 and set a section, in which charging from a seventh SOC level 322 to an eighth SOC level 323 is made, as the fourth sub-section 320. The fifth SOC level 312 and the eighth SOC level 323, and/or the sixth SOC level 313 and the seventh SOC level 322 may be set to be the same as each other or to be different from each other. In addition, an interval between the fifth SOC level 312 and the sixth SOC level 313 may be set to be the same as or to be different from an interval between the seventh SOC level 322 and the eighth SOC level 323. Further, the fifth SOC level 312 to the eighth SOC level 323 may be set to be the same as or different from the first SOC level 212 to the fourth SOC level 223 of FIG. 2. For example, the fifth SOC level 312 may be 100%, the sixth SOC level 313 may be 50%, the seventh SOC level 322 may be 25%, and the eighth SOC level 323 may be 75%.

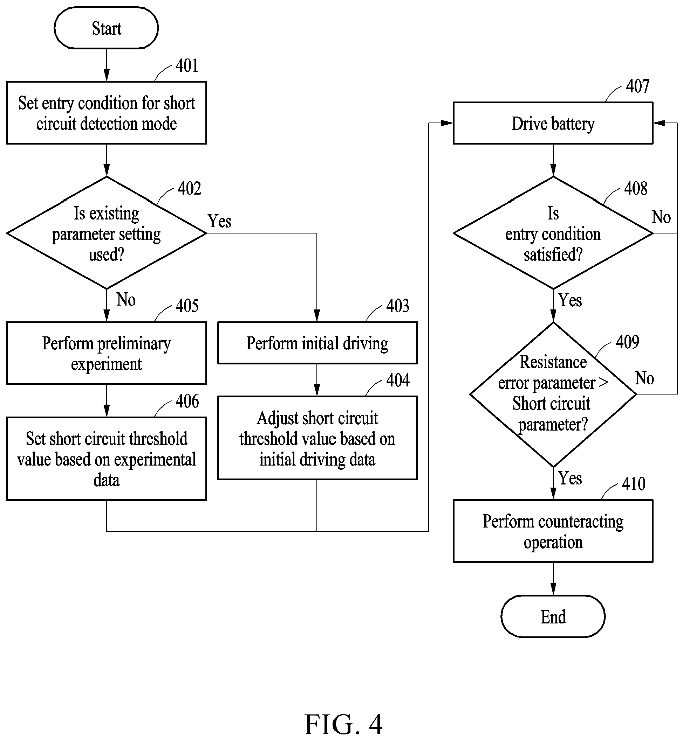

FIG. 4 illustrates an example of short circuit detection operations, according to one or more embodiments. Referring to FIG. 4, in operation 401, the short circuit detection apparatus may set an entry condition for entering a short circuit detection mode. The short circuit detection apparatus may either (i) always perform short circuit detection regardless of an internal state or surrounding environment of the battery or (ii) may perform short circuit detection under a specific internal state or specific surrounding environment. In the latter case (case (ii)), short circuit detection may be performed by entering the short circuit detection mode when specific internal state or specific surrounding environment satisfy the entry condition. For example, the entry condition may include a charge/discharge temperature, a charge/discharge range (e.g., a time range or a voltage range), a charge/discharge speed, and the like.

In operation 402, the short circuit detection apparatus may determine whether to use existing parameter setting. The existing parameter setting may correspond to a model and data set for another existing battery (an archetype battery), not the battery currently the subject of testing (the target battery).

When the existing/archetype parameter setting is used, in operation 403 the short circuit detection apparatus may perform initial driving of a current/target battery and, in operation 404, adjust a short circuit threshold value of the existing parameter setting based on corresponding initial driving data. For example, the initial driving data may be acquired according to driving during the initial 50 cycles of the current/target battery. The short circuit detection apparatus may determine the short circuit threshold value by adjusting maximum and minimum values of resistance error parameters of an existing/archetype battery based on maximum and minimum values of resistance error parameters according to the initial driving data. Operations 403 and 404 may be performed under an actual battery-driving environment in an electronic apparatus with the current/target battery mounted thereon.

According to an example embodiment, the short circuit detection apparatus may adjust the short circuit threshold value by shifting existing resistance error parameter values by applying a batch offset thereto, based on resistance error parameter values of the battery in the normal state, which are obtained during the initial driving in an on-device state. According to another example embodiment, the short circuit detection apparatus may adjust the short circuit threshold value by comparing parameter values of a battery model, other than the resistance error parameters of the battery in the normal state, which are obtained during the initial driving in the on-device state, with parameter values of the battery model, other than the existing resistance error parameters.

When the existing parameter setting is not used, the short circuit detection apparatus may perform a separate preliminary experiment using the current battery in operation 405, and may set a short circuit threshold value for the current battery based on experimental data obtained by the preliminary experiment in operation 406. For example, the preliminary experiment may include obtaining resistance error parameters of a (presumed) normal cell and an external resistance-connected cell by changing the charge/discharge temperature, the charge/discharge range, the charge/discharge speed, and the like, in a state where the entry condition is satisfied. The short circuit threshold value may be derived using maximum and minimum values of the resistance error parameter of the experimental data. Operations 405 and 406 may be performed under an experimental environment in an experimental device other than the electronic apparatus on which the current battery is to be mounted.

In operation 407, the battery driving may be performed. In operation 407, the battery driving may be performed in the electronic apparatus with the current (target) battery mounted thereon. In operation 408, the short circuit detection apparatus may determine whether the entry condition is satisfied. When the entry condition is satisfied, in operation 409, the short circuit detection apparatus may compare the resistance error parameter with the short circuit threshold value. The resistance error parameter may be calculated periodically during battery driving ("driving", as used herein, refers to charging or discharging), and the short circuit threshold value may be set in operation 404 or 406. When the resistance error parameter exceeds/satisfies the short circuit threshold value, in operation 410, the short circuit detection apparatus may perform a remediation operation. For example, the remediation operation may include issuing a signal or message related to a short circuit and/or notification thereof to a user.

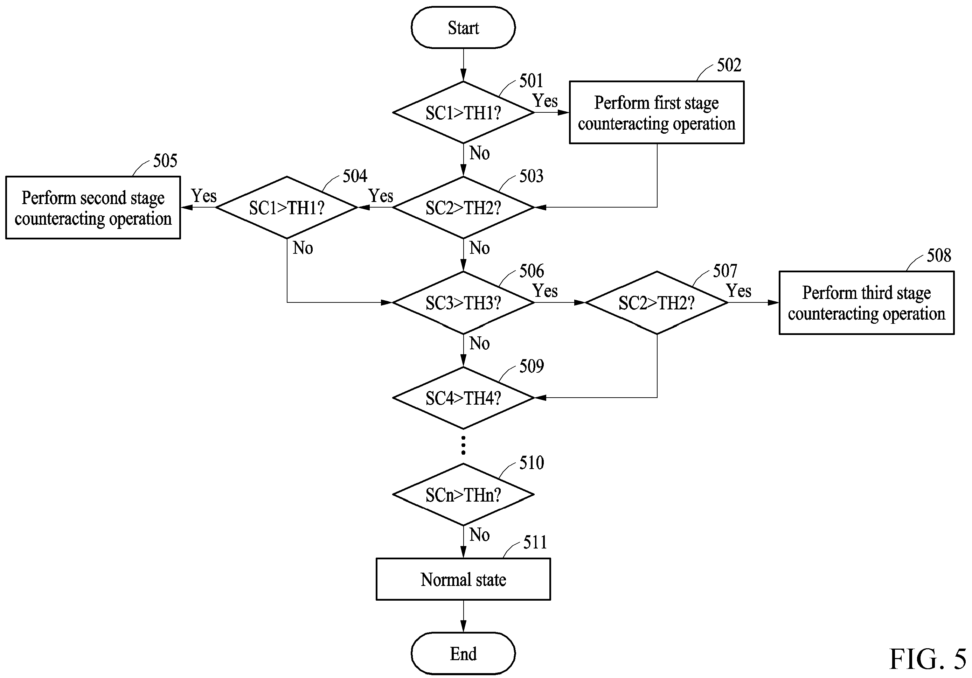

FIG. 5 illustrates an example of using sub-parameters of short circuit error parameters, according to one or more embodiments. According to an example embodiment, the short circuit (SC) error parameter may include 1 to n sub-parameters SC1 to SCn, and the short circuit detection apparatus may perform stepwise short circuit detection and a remediation by using the sub-parameters SC1 to SCn. For example, a first sub-parameter SC1 may correspond to a difference between the average resistance errors 211 and 221 of FIG. 2, a second sub-parameter SC2 may correspond to the rate of change 311 in the resistance error of FIG. 3, and a third sub-parameter SC3 may correspond to the rate of change 321 in the resistance error of FIG. 3. In some embodiments, only one sub-parameter is used.

Referring to FIG. 5, in operation 501, the short circuit detection apparatus may compare the first sub-parameter SC1 with a corresponding first short circuit threshold value TH1. When the first sub-parameter SC1 is greater than the first short circuit threshold value TH1, the short circuit detection apparatus may perform a first stage remediation operation in operation 502. For example, the first stage remediation operation may include generating a notification that may be rendered, in various ways, to inform a user of the occurrence of a micro-short circuit, to recommend battery replacement, etc.

In operation 503, the short circuit detection apparatus may compare the second sub-parameter SC2 with a corresponding second short circuit threshold value TH2, and in operation 504, the short circuit detection apparatus may again compare the first sub-parameter SC1 with the first short circuit threshold value TH1. When the second sub-parameter SC2 is greater than the second short circuit threshold value TH2 and the first sub-parameter SC1 is greater than the first short circuit threshold value TH1, the short circuit detection apparatus may perform a second stage remediation operation in operation 505. For example, the second stage remediation operation may include generating a notification of a battery short circuit and recommending battery replacement, for example. Operation 504 may be omitted, as necessary. In this case, since it is determined that the second sub-parameter SC2 is greater than the second short circuit threshold value TH2, operation 505 may be directly performed without operation 504.

In operations 506 to 508, the short circuit detection apparatus may perform the operations similar to operations 503 to 505. A third stage remediation operation may include continuously/repeatedly generating a notification as described above. Such operations may be continuously/repeatedly performed in operations 509 and 510 related to the fourth sub-parameter SC4, and so forth up to an n-th sub-parameter SCn. In operation 511, when all of the sub-parameters SC1 to SCn are smaller than their respectively corresponding short circuit threshold values TH1 to THn, the short circuit detection apparatus may determine that the battery is not in a short circuit state.

As the level of the remediation operation increases through progressive stages (e.g., first to third stages), the intensity/urgency of the content of the remediation operation may become stronger. For example, announcing a short circuit may be a stronger remediation operation than the announcing a micro-short circuit, and the request/recommendation for battery replacement and continuous notification may be a stronger remediation operation than the battery replacement recommendation. In this case, the order of the sub-parameters SC1 to SCn may be determined according to detection sensitivity thereof. The detection sensitivity may indicate a degree of sensitivity to a battery short circuit. For example, when a battery short circuit occurs in a state where the sub-parameters SC1 to SCn satisfy the respective short circuit threshold values TH1 to THn, the detection sensitivity may be set to be higher in an order of sub-parameters SC1 to SCn, that quickly exceed respectively corresponding values of the short circuit threshold values TH1 to Thn.

Although FIG. 5 illustrates an example embodiment of stepwise detection according to detection sensitivity, there may be various example embodiments of performing the short circuit detection by other methods. In some embodiments, a weight may be set for each of the sub-parameters TH1 to THn, and when a weighted sum of the weights exceeds a particular reference level (e.g., a threshold value), a counteracting operation may be performed. Also, in this case, several reference levels may be set, and a stronger counteracting operation may be performed according to how many stages a reference level passes through. According to another example embodiment, reference levels may be set for any one sub-parameter (e.g., the first sub-parameter TH1), and a stronger remediation operation may be performed according to which reference level the sub-parameter passes through.

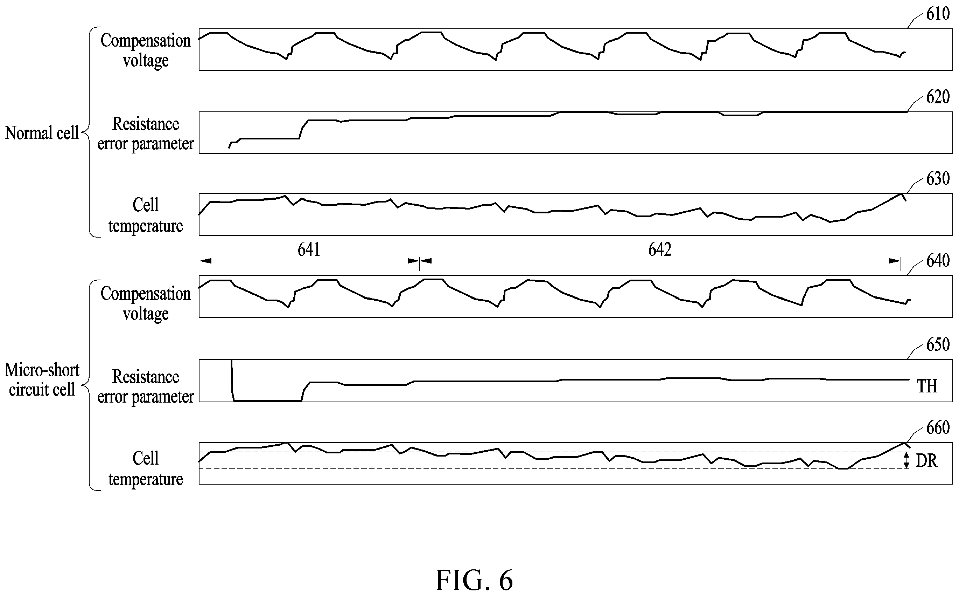

FIG. 6 illustrates an example of a data difference between a normal cell and a micro-short circuit cell, according to one or more embodiments. Referring to FIG. 6, graphs 610, 620, and 630 respectively show a compensation (correction) voltage, a resistance error parameter, and a cell temperature of a normal cell. The compensation voltage may indicate a compensation value or a correction value for correcting a difference between the estimated voltage and the actual voltage. Since the resistance error parameter of the normal cell is maintained to be lower than the short circuit threshold value in all sections of a graph 620, where charge and discharge are repeated, a battery short circuit may not be readily detected based thereon. Graphs 640, 650, and 660 respectively show a compensation voltage, a resistance error parameter, and a cell temperature of a micro-short circuit cell. The graph 650 shows a section in which the resistance error parameter exceeds the threshold value TH, and a micro-short circuit may be detected in this section.

In FIG. 6, a first section 641 corresponds to an initial driving section of a battery. In case of the first section 641, an initial error of a battery model may exist, and therefore, the short circuit detection may be performed in a second section 642 after the first section 641. The first section 641 and the second section 642 may correspond to a detection time range. In addition, the short circuit detection may be performed within a temperature detection range DR. The detection time range and the detection temperature range may correspond to satisfaction of entry conditions for the short circuit detection mode. An SOC range, a cut-off voltage range, or the like, may be set as the entry condition. When the entry condition is determined to be met, the short circuit detection apparatus may perform the short circuit detection by comparing the resistance error parameter with the short circuit threshold value in a situation where the entry condition is satisfied.

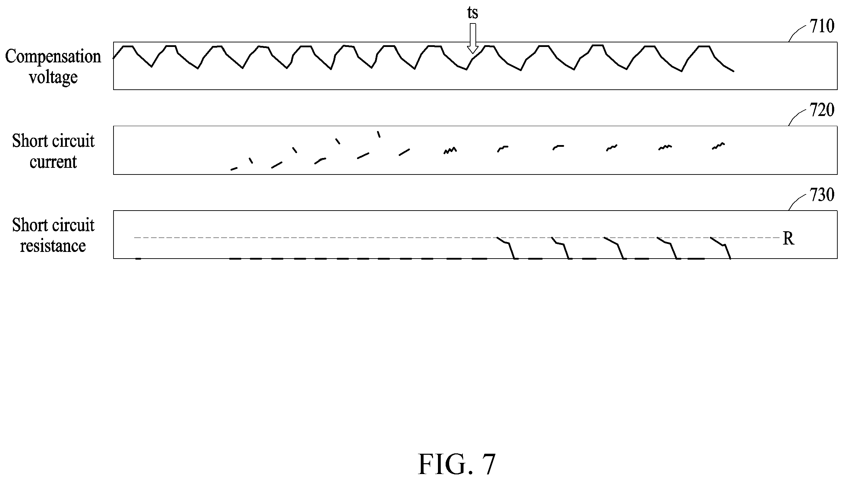

FIG. 7 illustrates an example of a process of deriving a short circuit resistance, according to one or more embodiments. Referring to FIG. 7, graphs 710 to 730 respectively show a compensation voltage, a short circuit current, and a short circuit resistance. A time ts indicates a short circuit detection time. A short circuit resistance value R may be a very small value, for example, 500 ohms. Despite a very small value of the short circuit resistances, a short circuit may be detected therefrom using the short circuit error parameter. The graphs 720 and 730 correspond to example results of short circuit detection performed in the discharging section, and accordingly, a broken section (charging section) is shown between lines.

When battery short circuit detection is performed, the short circuit detection apparatus may calculate a current short circuit resistance value from the resistance error parameter used for detecting the short circuit. For example, the short circuit detection apparatus may determine an internal resistance R_I of a battery based on an estimated voltage V_E (of estimation data) and a measured current I_M (of measurement data), determine an error ratio ER based on a ratio between the internal resistance R_I and a resistance error parameter (e.g., the first sub-parameter SC1), determine a short circuit current I_S based on a multiplication of the measured current I_M and the error ratio ER, and determine a short circuit resistance R_S (of a short circuit) based on a ratio between the estimated voltage V_E and the short circuit current I_S. For example, the internal resistance R_I may be calculated as the estimated voltage V_E / the measured current I_M, the error ratio ER may be calculated as the first sub-parameter SC1 / the internal resistance R_I, the short circuit current I_S may be calculated as the measured current I_M * the error ratio ER, and the short circuit resistance R_S may be calculated as the estimated voltage V_E / the short circuit current I_S. The calculated short circuit resistance R_S and/or short circuit current I_S may be used as detection parameters of short circuit detection.

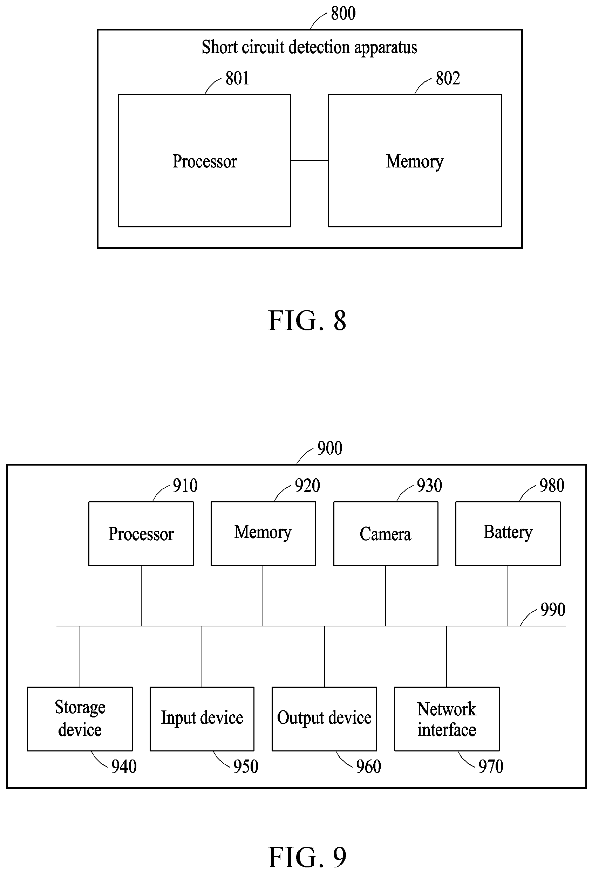

FIG. 8 illustrates a configuration of a short circuit detection apparatus, according to the present invention. Referring to FIG. 8, a short circuit detection apparatus 800 includes a processor 801 and a memory 802. The memory 802 may be connected to the processor 801, and stores instructions executable by the processor 801, data to be computed by the processor 801, or data processed by the processor 801 ("processor" refers to one or more processors, cores, etc.). The memory 802 includes a non-transitory computer-readable storage medium, for example, a high-speed random access memory (RAM) and/or a non-volatile computer-readable storage medium (for example, at least one disk storage device, a flash memory device, or other non-volatile solid state memory devices).

The processor 801 executes instructions to perform the operations described herein with reference to FIGS. 1 to 7, FIG. 9 and FIG. 10. For example, the processor 801 may measure a state of a battery in a target section including at least a portion of a charging section of a battery or a discharging section of the battery to determine measurement data, estimate the state of the battery in the target section using a battery model simulating the battery to determine estimation data, determine a resistance error parameter of the battery based on an error between the measurement data and the estimation data, and detect a short circuit of the battery based on a result of comparison between the resistance error parameter and a short circuit threshold value. In addition, the description provided with reference to FIGS. 1 to 7, FIG. 9, and FIG. 10 may be applicable to the short circuit detection apparatus 800.

FIG. 9 illustrates an example configuration of an electronic apparatus, according to one or more embodiments. Referring to FIG. 9, the electronic apparatus 900 may include a processor 910, a memory 920, a camera 930, a storage device 940, an input device 950, an output device 960, a network interface 970, and a battery 980, and these components may communicate with one another via a communication bus 990. For example, the electronic apparatus 900 may be embodied as at least a portion of a mobile device (e.g., a mobile phone, a smartphone, a personal digital assistant (PDA), a netbook, a tablet computer, a laptop computer, etc.), a wearable device (e.g., a smartwatch, a smart band, smart eyeglasses, etc.), a computing device (e.g., a desktop, a server, etc.), a home appliance (e.g., a television (TV), a smart TV, a refrigerator, etc.), a security device (e.g., a door lock, etc.), or a vehicle (e.g., an autonomous vehicle, a smart vehicle, etc.). The electronic apparatus 900 may structurally and/or functionally include the short circuit detection apparatus 100 of FIG. 1 and/or the short circuit detection apparatus 800 of FIG. 8.

The processor 910 may execute instructions and functions in the electronic apparatus 900. For example, the processor 910 may process instructions stored in the memory 920 or the storage device 940. The instructions may be configured such that when executed by the processor, the processor 910 performs operations described with reference to FIGS. 1 to 8. The memory 920 may include a non-transitory computer-readable storage medium or a non-transitory computer-readable storage device. The memory 920 may store instructions that are to be executed by the processor 910, and also store information associated with software and/or applications when the software and/or applications are being executed by the electronic apparatus 900.

The camera 930 may capture a photo and/or a video. For example, the camera 930 may capture a facial image including a face of a user. The camera 930 may be a three-dimensional (3D) camera including depth information associated with objects. The storage device 940 may include a non-transitory computer-readable storage medium or a non-transitory computer-readable storage device. The storage device 940 may store a greater amount of information than the memory 920 and store the information for a long period of time. For example, the storage device 940 may include magnetic hard disks, optical disks, flash memories, floppy disks, or other forms of non-volatile memories known in the art.

The input device 950 may receive an input from a user through a traditional input scheme using a keyboard and a mouse, and through a new input scheme such as a touch input, a voice input and an image input. For example, the input device 950 may detect an input from a keyboard, a mouse, a touchscreen, a microphone or a user, and may include any other device configured to transfer the detected input to the electronic apparatus 900. The output device 960 may provide a user with an output of the electronic apparatus 900 through a visual channel, an auditory channel, or a tactile channel. The output device 960 may include, for example, a display, a touchscreen, a speaker, a vibration generator, or any other device configured to provide a user with the output. The network interface 970 may communicate with an external device via a wired or wireless network. The battery 980 may store power, and may provide the power to the electronic apparatus 900.

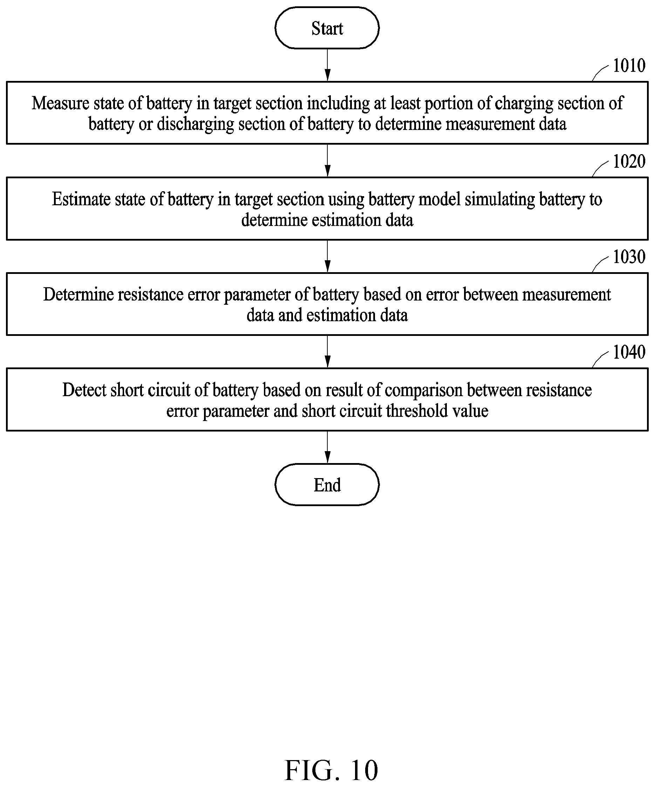

FIG. 10 illustrates a short circuit detection method, according to the present invention. Referring to FIG. 10, the short circuit detection apparatus measures a battery in a target section (timespan) including at least a portion of a charging section of a battery or a discharging section of the battery to determine measurement data in operation 1010, estimates the state of the battery in the target section using a battery model simulating the battery to determine estimation data in operation 1020, determines a resistance error parameter of the battery based on an error between the measurement data and the estimation data in operation 1030, and detects a short circuit of the battery based on a result of comparison between the resistance error parameter and a short circuit threshold value in operation 1040.

The measurement data may include a measured voltage and a measured current, the estimation data may include an estimated voltage, and the resistance error parameter may be determined based on a ratio between a voltage error and the measured current (the voltage error corresponding to a difference between the measured voltage and the estimated voltage).

The resistance error parameter may include (i) a first sub-parameter representing a difference between a first average resistance error in a first sub-section of the discharging section and a second average resistance error in a second sub-section of the charging section, (ii) a second sub-parameter representing a rate of change in a resistance error in a third sub-section of the discharging section, and/or (iii) a third sub-parameter representing a rate of change in a resistance error in a fourth sub-section of the charging section.

The measurement data may include battery measurement values of a preset detection period, the estimation data may include battery estimation values of the preset detection period, resistance error values of the preset detection period may be determined based on the measurement values and the estimation values, and the resistance error parameter may correspond to an operation result obtained based on the resistance error values.

Operation 1030 may include determining the first average resistance error based on an average of the resistance error values in the first sub-section, determining the second average resistance error based on an average of the resistance error values in the second sub-section, and determining the first sub-parameter based on a difference between the first average resistance error and the second average resistance error.

Operation 1030 may include determining the second sub-parameter based on a rate of increase in an error of the resistance error values in the third sub-section.

Operation 1030 may include determining the third sub-parameter based on a rate of decrease in an error of the resistance error values in the fourth sub-section.

The resistance error parameter may include a sub-parameters having different degrees of detection sensitivity, and different respective remediation operations that are performed depending on the degrees of detection sensitivity of the sub-parameters.

Operation 1040 may include determining an internal resistance of the battery based on an estimated voltage of the estimation data and a measured current of the measurement data, determining an error ratio based on a ratio between the internal resistance and the resistance error parameter, determining a short circuit current based on a multiplication of the measured current and the error ratio, and determining a short circuit resistance of the short circuit based on a ratio between the estimated voltage and the short circuit current.

An entry condition for a short circuit detection mode may set in advance and may include one or more of a charging/discharging temperature, a charging/discharging range, or a charging/discharging speed, and operations 1010 to 1040 may be performed based on satisfaction of the entry condition.

The short circuit threshold value may be determined based on a preliminary experimental result, may be determined based on an actual driving result during an initial driving section of the battery, or may be determined by adjusting an existing experimental result to the actual driving result.

In addition, the description provided with reference to FIGS. 1 to 9 may be applicable to the short circuit detection method of FIG. 10.

The computing apparatuses, the electronic devices, the processors, the memories, the image sensors/cameras, the displays, the information output system and hardware, the storage devices, and other apparatuses, devices, units, modules, and components described herein with respect to FIGS. 1-10 are implemented by or representative of hardware components. Examples of hardware components that may be used to perform the operations described in this application where appropriate include controllers, sensors, generators, drivers, memories, comparators, arithmetic logic units, adders, subtractors, multipliers, dividers, integrators, and any other electronic components configured to perform the operations described in this application. In other examples, one or more of the hardware components that perform the operations described in this application are implemented by computing hardware, for example, by one or more processors or computers. A processor or computer may be implemented by one or more processing elements, such as an array of logic gates, a controller and an arithmetic logic unit, a digital signal processor, a microcomputer, a programmable logic controller, a field-programmable gate array, a programmable logic array, a microprocessor, or any other device or combination of devices that is configured to respond to and execute instructions in a defined manner to achieve a desired result. In one example, a processor or computer includes, or is connected to, one or more memories storing instructions or software that are executed by the processor or computer. Hardware components implemented by a processor or computer may execute instructions or software, such as an operating system (OS) and one or more software applications that run on the OS, to perform the operations described in this application. The hardware components may also access, manipulate, process, create, and store data in response to execution of the instructions or software. For simplicity, the singular term "processor" or "computer" may be used in the description of the examples described in this application, but in other examples multiple processors or computers may be used, or a processor or computer may include multiple processing elements, or multiple types of processing elements, or both. For example, a single hardware component or two or more hardware components may be implemented by a single processor, or two or more processors, or a processor and a controller. One or more hardware components may be implemented by one or more processors, or a processor and a controller, and one or more other hardware components may be implemented by one or more other processors, or another processor and another controller. One or more processors, or a processor and a controller, may implement a single hardware component, or two or more hardware components. A hardware component may have any one or more of different processing configurations, examples of which include a single processor, independent processors, parallel processors, single-instruction single-data (SISD) multiprocessing, single-instruction multiple-data (SIMD) multiprocessing, multiple-instruction single-data (MISD) multiprocessing, and multiple-instruction multiple-data (MIMD) multiprocessing.

The methods illustrated in FIGS. 1-10 that perform the operations described in this application are performed by computing hardware, for example, by one or more processors or computers, implemented as described above implementing instructions or software to perform the operations described in this application that are performed by the methods. For example, a single operation or two or more operations may be performed by a single processor, or two or more processors, or a processor and a controller. One or more operations may be performed by one or more processors, or a processor and a controller, and one or more other operations may be performed by one or more other processors, or another processor and another controller. One or more processors, or a processor and a controller, may perform a single operation, or two or more operations.

Instructions or software to control computing hardware, for example, one or more processors or computers, to implement the hardware components and perform the methods as described above may be written as computer programs, code segments, instructions or any combination thereof, for individually or collectively instructing or configuring the one or more processors or computers to operate as a machine or special-purpose computer to perform the operations that are performed by the hardware components and the methods as described above. In one example, the instructions or software include machine code that is directly executed by the one or more processors or computers, such as machine code produced by a compiler. In another example, the instructions or software includes higher-level code that is executed by the one or more processors or computer using an interpreter. The instructions or software may be written using any programming language based on the block diagrams and the flow charts illustrated in the drawings and the corresponding descriptions herein, which disclose algorithms for performing the operations that are performed by the hardware components and the methods as described above.

The instructions or software to control computing hardware, for example, one or more processors or computers, to implement the hardware components and perform the methods as described above, and any associated data, data files, and data structures, may be recorded, stored, or fixed in or on one or more non-transitory computer-readable storage media. Examples of a non-transitory computer-readable storage medium include read-only memory (ROM), random-access programmable read only memory (PROM), electrically erasable programmable read-only memory (EEPROM), random-access memory (RAM), dynamic random access memory (DRAM), static random access memory (SRAM), flash memory, non-volatile memory, CD-ROMs, CD-Rs, CD+Rs, CD-RWs, CD+RWs, DVD-ROMs, DVD- Rs, DVD+Rs, DVD-RWs, DVD+RWs, DVD-RAMs, BD-ROMs, BD-Rs, BD-R LTHs, BD-REs, blue-ray or optical disk storage, hard disk drive (HDD), solid state drive (SSD), flash memory, a card type memory such as multimedia card micro or a card (for example, secure digital (SD) or extreme digital (XD)), magnetic tapes, floppy disks, magneto-optical data storage devices, optical data storage devices, hard disks, solid-state disks, and any other device that is configured to store the instructions or software and any associated data, data files, and data structures in a non-transitory manner and provide the instructions or software and any associated data, data files, and data structures to one or more processors or computers so that the one or more processors or computers can execute the instructions. In one example, the instructions or software and any associated data, data files, and data structures are distributed over network-coupled computer systems so that the instructions and software and any associated data, data files, and data structures are stored, accessed, and executed in a distributed fashion by the one or more processors or computers.

While this disclosure includes specific examples, it will be apparent after an understanding of the disclosure of this application that various changes in form and details may be made in these examples without departing from the scope of the claims. The examples described herein are to be considered in a descriptive sense only, and not for purposes of limitation. Descriptions of features or aspects in each example are to be considered as being applicable to similar features or aspects in other examples. Suitable results may be achieved if the described techniques are performed in a different order, and/or if components in a described system, architecture, device, or circuit are combined in a different manner, and/or replaced or supplemented by other components or their equivalents.

Therefore, the scope of the invention is defined by the appended claims.

## Claims

1. A short circuit detecting method, comprising:
determining measurement data (101) by measuring a battery (110) for a target timespan comprising a battery charging timespan and a battery discharging timespan;
determining estimation data (102) of the battery (110) for the target timespan using a battery model (121) that simulates the battery to determine the estimation data (102);
determining (1030) a resistance error parameter of the battery (110) based on the measurement data (101) and the estimation data (102); and
determining (1040) that a battery short circuit condition is satisfied based on a result of comparing the resistance error parameter and a short circuit threshold value,
**characterised in that**
the resistance error parameter comprises a first sub-parameter representing a difference between a first average resistance error (211) in a first sub-timespan (210) of the discharging timespan and a second average resistance error (221) in a second sub-timespan (220) of the charging timespan.

2. The method of claim 1, wherein
the measurement data (101) comprises a measured voltage and a measured current, the estimation data (102) comprises an estimated voltage, and
the resistance error parameter is determined based on a ratio between a voltage error and
the measured current, the voltage error corresponding to a difference between the measured voltage and the estimated voltage.

3. The method of claim 1 or 2, wherein the resistance error parameter further comprises one or more of:
a second sub-parameter representing a rate of change (311) in a resistance error in a third sub-timespan (310) of the discharging timespan; and
a third sub-parameter representing a rate of change (321) in a resistance error in a fourth sub-timespan (320) of the charging timespan,
wherein the measurement data (101) comprises battery measurement values of a preset detection interval,
the estimation data (102) comprises battery estimation values of the preset detection interval,
resistance error values of the preset detection interval are determined based on the measurement values and the estimation values, and
the resistance error parameter corresponds to an operation result obtained based on the resistance error values.

4. The method of claim 3, wherein the determining the resistance error parameter comprises one or more of:
determining the first average resistance error based on an average of the resistance error values in the first sub-timespan, determining the second average resistance error based on an average of the resistance error values in the second sub-timespan, and determining the first sub-parameter based on a difference between the first average resistance error and the second average resistance error;
determining the second sub-parameter based on a rate of increase in an error of the resistance error values in the third sub-timespan; and
determining the third sub-parameter based on a rate of decrease in an error of the resistance error values in the fourth sub-timespan.

5. The method of one of claims 1 to 4, wherein
the resistance error parameter comprises sub-parameters having different degrees of short-detection sensitivity, and
different remediation operations are performed in accordance with the degrees of short-detection sensitivity.

6. The method of one of claims 1 to 5, wherein the determining that the battery short circuit condition is satisfied comprises:
determining an internal resistance of the battery (110) based on an estimated voltage of the estimation data (102) and a measured current of the measurement data (101);
determining an error ratio based on a ratio between the internal resistance and the resistance error parameter;
determining a short circuit current based on a multiplication of the measured current and the error ratio; and
determining a short circuit resistance of the short circuit based on a ratio between the estimated voltage and the short circuit current.

7. The method of one of claims 1 to 6, wherein
an entry condition for a short circuit detection mode comprises a charging/discharging temperature, a charging/discharging range, and/or a charging/discharging speed, and
the determining the measurement data (101), the determining the estimation data (102), the determining the resistance error parameter, and the determining that a battery short circuit condition is satisfied are performed based on satisfaction of the entry condition.

8. The method of one of claims 1 to 7, wherein the short circuit threshold value is determined based on a preliminary experimental result, is determined based on an actual driving result during an initial driving section of the battery, or is determined by adjusting an existing experimental result to the actual driving result.

9. A short circuit detection apparatus, comprising:
one or more processors (801); and
a memory (802) storing instructions configured to, when executed by the one or more processors (801), cause the one or more processors (801) to:
determine measurement data (101) by measuring a battery (110) in a target timespan comprising at least a charging timespan of charging the battery (110) and a discharging timespan of discharging the battery (110);
determine estimation data (102) of the battery (110) for the target timespan using a battery model (121) that simulates the battery;
determine (1030) a resistance error parameter of the battery (110) based on an error between the measurement data (101) and the estimation data (102); and
detect (1040) a short circuit of the battery (110) based on a result of comparison between the resistance error parameter and a short circuit threshold value,
**characterised in that**
the resistance error parameter comprises a first sub-parameter representing a difference between a first average resistance error in a first sub-timespan of the discharging timespan and a second average resistance error in a second sub-timespan of the charging timespan.

10. The apparatus of claim 9, wherein
the measurement data (101) comprises a measured voltage and a measured current, the estimation data (102) comprises an estimated voltage, and
the resistance error parameter is determined based on a ratio between a voltage error and the measured current, the voltage error corresponding to a difference between the measured voltage and the estimated voltage.

11. The apparatus of claim 9 or 10, wherein the resistance error parameter further comprises one or more of:
a second sub-parameter representing a rate of change in a resistance error in a third sub-timespan of the discharging timespan; and
a third sub-parameter representing a rate of change in a resistance error in a fourth sub-timespan of the charging timespan.

12. The apparatus of one of claims 9 to 11, wherein
the resistance error parameter comprises sub-parameters having different degrees of detection sensitivity to a short circuit of the battery (110), and
different remediation operations are performed in accordance with the degrees of detection sensitivity.

13. The apparatus of one of claims 9 to 12, wherein the instructions are further configured to cause the one or more processors to:
determine an internal resistance of the battery (110) based on an estimated voltage of the estimation data (102) and a measured current of the measurement data (101);
determine an error ratio based on a ratio between the internal resistance and the resistance error parameter;
determine a short circuit current based on a multiplication of the measured current and the error ratio; and
determine a short circuit resistance based on a ratio between the estimated voltage and the short circuit current.

14. A non-transitory computer-readable storage medium storing instructions that, when executed by one or more processors of an apparatus comprising a battery (110) configured to supply power to the apparatus, cause the one or more processors to:
measure measurement data (101) of a battery (110) for a timespan during which the battery (110) is being charged and is being discharged;
estimate estimation data (102) of the battery (110) based on an output of a battery model (121) that simulates the battery (110);
determine (1030) a resistance error parameter of the battery (110) based on the measurement data (101) and the estimation data (102); and
detect (1040) a short circuit of the battery (110) based the resistance error parameter and a short circuit threshold value,
**characterised in that**
the resistance error parameter comprises a first sub-parameter representing a difference between a first average resistance error in a first sub-timespan during which the battery (110) is discharged and a second average resistance error in a second sub-timespan during which the battery (110) is charged.

15. The computer-readable storage medium of claim 14, wherein the measurement data (101) comprises a measured voltage and a measured current, the estimation data (102) comprises an estimated voltage, and the resistance error parameter is determined based on a ratio between a voltage error and the measured current, the voltage error corresponding to a difference between the measured voltage and the estimated voltage, or
wherein estimation data (102) is provided by the model based on the measurement data (101), and wherein the short circuit is detected based on evaluating the resistance error parameter against a short circuit threshold value.

## Patentansprüche

1. Verfahren zur Erfassung eines Kurzschlusses, umfassend:
Bestimmen von Messdaten (101) durch Messen einer Batterie (110) für eine Zielzeitspanne, die eine Batterieladezeitspanne und eine Batterieentladezeitspanne aufweist;
Bestimmen von Schätzdaten (102) der Batterie (110) für die Zielzeitspanne unter Verwendung eines Batteriemodells (121), welches die Batterie simuliert, um die Schätzdaten (102) zu bestimmen;
Bestimmen (1030) eines Widerstandsfehlerparameters der Batterie (110) auf der Grundlage der Messdaten (101) und der Schätzdaten (102); und
Bestimmen (1040), dass eine Batteriekurzschlussbedingung erfüllt ist, auf der Grundlage eines Ergebnisses des Vergleichs des Widerstandsfehlerparameters und eines Kurzschluss-Schwellenwerts,
**dadurch gekennzeichnet, dass**
der Widerstandsfehlerparameter einen ersten Unterparameter aufweist, der eine Differenz zwischen einem ersten durchschnittlichen Widerstandsfehler (211) in einer ersten Teilzeitspanne (210) der Entladezeitspanne und einem zweiten durchschnittlichen Widerstandsfehler (221) in einer zweiten Teilzeitspanne (220) der Ladezeitspanne darstellt.

2. Verfahren nach Anspruch 1, wobei
die Messdaten (101) eine gemessene Spannung und einen gemessenen Strom aufweisen,
die Schätzdaten (102) eine geschätzte Spannung aufweisen, und
der Widerstandsfehlerparameter auf der Grundlage eines Verhältnisses zwischen einem Spannungsfehler und dem gemessenen Strom bestimmt wird, wobei der Spannungsfehler einer Differenz zwischen der gemessenen Spannung und der geschätzten Spannung entspricht.

3. Verfahren nach Anspruch 1 oder 2, wobei der Widerstandsfehlerparameter ferner eines oder mehrere der folgenden Elemente aufweist:
einen zweiten Unterparameter, der eine Änderungsrate (311) eines Widerstandsfehlers in einer dritten Teilzeitspanne (310) der Entladezeitspanne darstellt; und
einen dritten Unterparameter, der eine Änderungsrate (321) eines Widerstandsfehlers in einer vierten Teilzeitspanne (320) der Ladezeitspanne darstellt,
wobei die Messdaten (101) Batteriemesswerte eines voreingestellten Erfassungsintervalls aufweisen,
die Schätzdaten (102) Batterieschätzwerte des voreingestellten Erfassungsintervalls aufweisen,
Widerstandsfehlerwerte des voreingestellten Erfassungsintervalls auf der Grundlage der Messwerte und der Schätzwerte bestimmt werden und
der Widerstandsparameter einem auf der Grundlage der Widerstandfehlerwerte ermittelten Betriebsergebnis entspricht.

4. Verfahren nach Anspruch 3, wobei das Bestimmen des Widerstandsfehlerparameters eines oder mehrere der folgenden Schritte umfasst:
Bestimmen des ersten durchschnittlichen Widerstandsfehlers auf der Grundlage eines Durchschnitts der Widerstandsfehlerwerte in der ersten Teilzeitspanne, Bestimmen des zweiten durchschnittlichen Widerstandsfehlers auf der Grundlage eines Durchschnitts der Widerstandsfehlerwerte in der zweiten Teilzeitspanne und Bestimmen des ersten Unterparameters auf der Grundlage einer Differenz zwischen dem ersten durchschnittlichen Widerstandsfehler und dem zweiten durchschnittlichen Widerstandsfehler;
Bestimmen des zweiten Unterparameters auf der Grundlage eines Anstiegs eines Fehlers der Widerstandsfehlerwerte in der dritten Teilzeitspanne; und
Bestimmen des dritten Unterparameters auf der Grundlage einer Abnahme eines Fehlers der Widerstandsfehlerwerte in der vierten Teilzeitspanne.

5. Verfahren nach einem der Ansprüche 1 bis 4, wobei
der Widerstandsfehlerparameter Unterparameter mit unterschiedlichen Graden der Kurzschlusserfassungsempfindlichkeit aufweist und
unterschiedliche Korrekturmaßnahmen entsprechend den Graden der Kurzschlusserfassungsempfindlichkeit durchgeführt werden.

6. Verfahren nach einem der Ansprüche 1 bis 5, wobei das Bestimmen, dass die Batteriekurzschlussbedingung erfüllt ist, umfasst:
Bestimmen eines Innenwiderstands der Batterie (110) auf der Grundlage einer geschätzten Spannung der Schätzdaten (102) und eines gemessenen Stroms der Messdaten (101);
Bestimmen eines Fehlerverhältnisses auf der Grundlage eines Verhältnisses zwischen dem Innenwiderstand und dem Widerstandsfehlerparameter;
Bestimmen eines Kurzschlussstroms auf der Grundlage einer Multiplikation des gemessenen Stroms und des Fehlerverhältnisses; und
Bestimmen eines Kurzschlusswiderstands des Kurzschlusses auf der Grundlage eines Verhältnisses zwischen der geschätzten Spannung und dem Kurzschlussstrom.

7. Verfahren nach einem der Ansprüche 1 bis 6, wobei
eine Eingangsbedingung für einen Kurzschlusserfassungsmodus eine Lade-/Entladetemperatur, einen Lade-/Entladebereich und/oder eine Lade-/Entladegeschwindigkeit aufweist, und
das Bestimmen der Messdaten (101), das Bestimmen der Schätzdaten (102), das Bestimmen des Widerstandsfehlerparameters und das Bestimmen, dass eine Batteriekurzschlussbedingung erfüllt ist, auf der Grundlage einer Erfüllung der Eingangsbedingung durchgeführt werden.

8. Verfahren nach einem der Ansprüche 1 bis 7, wobei der Kurzschluss-Schwellenwert auf der Grundlage eines vorläufigen Versuchsergebnisses bestimmt wird, auf der Grundlage eines tatsächlichen Fahrergebnisses während eines anfänglichen Fahrabschnitts der Batterie bestimmt wird oder durch Anpassen eines vorhandenen Versuchsergebnisses an das tatsächliche Fahrergebnis bestimmt wird.

9. Kurzschlusserfassungsvorrichtung, aufweisend:
einen oder mehrere Prozessoren (801); und
einen Speicher (802), der Anweisungen speichert, die so konfiguriert sind, dass sie, wenn sie von dem einen oder den mehreren Prozessoren (801) ausgeführt werden, den einen oder die mehreren Prozessoren (801) dazu veranlassen:
Messdaten (101) durch Messen einer Batterie (110) in einer Zielzeitspanne zu bestimmen, die mindestens eine Ladezeitspanne zum Laden der Batterie (110) und eine Entladezeitspanne zum Entladen der Batterie (110) aufweist;
Schätzdaten (102) der Batterie (110) für die Zielzeitspanne unter Verwendung eines Batteriemodells (121) zu bestimmen, welches die Batterie simuliert;
eine Widerstandsfehlerparameter der Batterie (110) auf der Grundlage eines Fehlers zwischen den Messdaten (101) und den Schätzdaten (102) zu bestimmen (1030); und
einen Kurzschluss der Batterie (110) auf der Grundlage eines Vergleichsergebnisses zwischen dem Widerstandsfehlerparameter und einem Kurzschluss-Schwellenwert zu erfassen (1040),
**dadurch gekennzeichnet, dass**
der Widerstandsfehlerparameter einen ersten Unterparameter aufweist, der eine Differenz zwischen einem ersten durchschnittlichen Widerstandsfehler in einer ersten Teilzeitspanne der Entladezeitspanne und einem zweiten durchschnittlichen Widerstandsfehler in einer zweiten Teilzeitspanne der Ladezeitspanne darstellt.

10. Vorrichtung nach Anspruch 9, wobei
die Messdaten (101) eine gemessene Spannung und einen gemessenen Strom aufweisen,
die Schätzdaten (102) eine geschätzte Spannung aufweisen und
der Widerstandsfehlerparameter auf der Grundlage eines Verhältnisses zwischen einem Spannungsfehler und dem gemessenen Strom bestimmt wird, wobei der Spannungsfehler einer Differenz zwischen der gemessenen Spannung und der geschätzten Spannung entspricht.

11. Vorrichtung nach Anspruch 9 oder 10, wobei der Widerstandsfehlerparameter ferner eines oder mehrere der folgenden Elemente aufweist:
einen zweiten Unterparameter, der eine Änderungsrate eines Widerstandsfehlers in einer dritten Teilzeitspanne der Entladezeitspanne darstellt; und
einen dritten Unterparameter, der eine Änderungsrate eines Widerstandsfehlers in einer vierten Teilzeitspanne der Ladezeitspanne darstellt.

12. Vorrichtung nach einem der Ansprüche 9 bis 11, wobei
der Widerstandsfehlerparameter Unterparameter mit unterschiedlichen Graden einer Erfassungsempfindlichkeit für einen Kurzschluss der Batterie (110) aufweist und
unterschiedliche Korrekturmaßnahmen entsprechend den Graden der Erfassungsempfindlichkeit durchgeführt werden.

13. Vorrichtung nach einem der Ansprüche 9 bis 12, wobei die Anweisungen ferner so konfiguriert sind, dass sie den einen oder die mehreren Prozessoren veranlassen:
einen Innenwiderstand der Batterie (110) auf der Grundlage einer geschätzten Spannung der Schätzdaten (102) und eines gemessenen Stroms der Messdaten (101) zu bestimmen;
ein Fehlerverhältnis auf der Grundlage eines Verhältnisses zwischen dem Innenwiderstand und dem Widerstandsfehlerparameter zu bestimmen;
einen Kurzschlussstrom auf der Grundlage einer Multiplikation des gemessenen Stroms und des Fehlerverhältnisses zu bestimmen; und
einen Kurzschlusswiderstand auf der Grundlage eines Verhältnisses zwischen der geschätzten Spannung und dem Kurzschlussstrom zu bestimmen.

14. Nicht-transitorisches, computerlesbares Speichermedium, das Anweisungen speichert, die, bei Ausführung durch einen oder mehrere Prozessoren einer Vorrichtung, die eine Batterie (110) aufweist, welche so konfiguriert ist, dass sie der Vorrichtung eine Leistung zuführt, den einen oder die mehreren Prozessoren veranlassen:
Messdaten (101) einer Batterie (110) für eine Zeitspanne zu messen, während der die Batterie (110) geladen wird und während der sie entladen wird;
Schätzdaten (102) der Batterie (110) auf der Grundlage einer Ausgabe eines Batteriemodells (121) zu schätzen, welches die Batterie (110) simuliert;
einen Widerstandsfehlerparameter der Batterie (110) auf der Grundlage der Messdaten (101) und der Schätzdaten (102) zu bestimmen (1030); und
einen Kurzschluss der Batterie (110) auf der Grundlage des Widerstandsfehlerparameters und eines Kurzschluss-Schwellenwerts zu erfassen (1040),
**dadurch gekennzeichnet, dass**
der Widerstandsfehlerparameter einen ersten Unterparameter aufweist, der eine Differenz zwischen einem ersten durchschnittlichen Widerstandsfehler in einer ersten Teilzeitspanne, während der die Batterie (110) entladen wird, und einem zweiten durchschnittlichen Widerstandsfehler in einer zweiten Teilzeitspanne darstellt, während der die Batterie (110) geladen wird.

15. Computerlesbares Speichermedium nach Anspruch 14, wobei die Messdaten (101) eine gemessene Spannung und einen gemessenen Strom aufweisen, die Schätzdaten (120) eine geschätzte Spannung aufweisen und der Widerstandsfehlerparameter auf der Grundlage eines Verhältnisses zwischen einem Spannungsfehler und dem gemessenen Strom bestimmt wird, wobei der Spannungsfehler einer Differenz zwischen der gemessenen Spannung und der geschätzten Spannung entspricht, oder
wobei die Schätzdaten (102) durch das Modell auf der Grundlage der Messdaten (101) bereitgestellt werden und wobei der Kurzschluss auf der Grundlage einer Bewertung des Widerstandsfehlerparameters anhand eines Kurzschluss-Schwellenwerts erfasst wird.

## Revendications

1. Procédé de détection de court-circuit, comprenant :
déterminer des données de mesure (101) en mesurant une batterie (110) pendant un intervalle de temps cible comprenant un intervalle de temps de charge de la batterie et un intervalle de temps de décharge de la batterie ;
déterminer des données d'estimation (102) de la batterie (110) pour l'intervalle de temps cible au moyen d'un modèle de batterie (121) qui simule la batterie afin de déterminer les données d'estimation (102) ;
déterminer (1030) un paramètre d'erreur de résistance de la batterie (110) sur la base des données de mesure (101) et des données d'estimation (102) ; et
déterminer (1040) qu'une condition de court-circuit de batterie est satisfaite sur la base d'un résultat de comparaison entre le paramètre d'erreur de résistance et une valeur seuil de court-circuit,
**caractérisé en ce que**
le paramètre d'erreur de résistance comprend un premier sous-paramètre représentant une différence entre une première erreur de résistance moyenne (211) dans un premier sous-intervalle de temps (210) de l'intervalle de temps de décharge et une deuxième erreur de résistance moyenne (221) dans un deuxième sous-intervalle de temps (220) de l'intervalle de temps de charge.

2. Procédé selon la revendication 1, dans lequel :
les données de mesure (101) comprennent une tension mesurée et un courant mesuré,
les données d'estimation (102) comprennent une tension estimée, et
le paramètre d'erreur de résistance est déterminé sur la base d'un rapport entre une erreur de tension et le courant mesuré, l'erreur de tension correspondant à une différence entre la tension mesurée et la tension estimée.

3. Procédé selon la revendication 1 ou 2, dans lequel le paramètre d'erreur de résistance comprend en outre un ou plusieurs des éléments suivants :
un deuxième sous-paramètre représentant un taux de variation (311) d'une erreur de résistance dans un troisième sous-intervalle de temps (310) de l'intervalle de temps de décharge ; et
un troisième sous-paramètre représentant un taux de variation (321) d'une erreur de résistance dans un quatrième sous-intervalle de temps (320) de l'intervalle de temps de charge,
dans lequel les données de mesure (101) comprennent des valeurs de mesure de la batterie associées à un intervalle de détection prédéfini,
les données d'estimation (102) comprennent des valeurs d'estimation de la batterie associées à l'intervalle de détection prédéfini,
des valeurs d'erreur de résistance de l'intervalle de détection prédéfini sont déterminées sur la base des valeurs de mesure et des valeurs d'estimation, et
le paramètre d'erreur de résistance correspond à un résultat d'une opération de calcul obtenu sur la base des valeurs d'erreur de résistance.

4. Procédé selon la revendication 3, dans lequel la détermination du paramètre d'erreur de résistance comprend un ou plusieurs des actions suivantes :
déterminer la première erreur de résistance moyenne sur la base d'une moyenne des valeurs d'erreur de résistance dans le premier sous-intervalle de temps, déterminer la deuxième erreur de résistance moyenne sur la base d'une moyenne des valeurs d'erreur de résistance dans le deuxième sous-intervalle de temps, et déterminer le premier sous-paramètre sur la base d'une différence entre la première erreur de résistance moyenne et la deuxième erreur de résistance moyenne ;
déterminer le deuxième sous-paramètre sur la base d'un taux d'augmentation de l'erreur des valeurs d'erreur de résistance dans le troisième sous-intervalle de temps ; et
déterminer le troisième sous-paramètre sur la base d'un taux de diminution de l'erreur des valeurs d'erreur de résistance dans le quatrième sous-intervalle de temps.

5. Procédé selon l'une quelconque des revendications 1 à 4, dans lequel :
le paramètre d'erreur de résistance comprend des sous-paramètres présentant des degrés différents de sensibilité de détection de court-circuit, et
des mesures correctives différentes sont mises en œuvre en fonction des degrés de sensibilité de détection de court-circuit.

6. Procédé selon l'une quelconque des revendications 1 à 5, dans lequel la détermination selon laquelle la condition de court-circuit de batterie est satisfaite comprend :
déterminer une résistance interne de la batterie (110) sur la base d'une tension estimée des données d'estimation (102) et d'un courant mesuré des données de mesure (101) ;
déterminer un rapport d'erreur sur la base d'un rapport entre la résistance interne et le paramètre d'erreur de résistance ;
déterminer un courant de court-circuit sur la base d'une multiplication du courant mesuré et du rapport d'erreur ; et
déterminer une résistance de court-circuit sur la base d'un rapport entre la tension estimée et le courant de court-circuit.

7. Procédé selon l'une quelconque des revendications 1 à 6, dans lequel :
une condition d'entrée pour un mode de détection de court-circuit comprend une température de charge/décharge, une plage de charge/décharge et/ou une vitesse de charge/décharge, et
la détermination des données de mesure (101), la détermination des données d'estimation (102), la détermination du paramètre d'erreur de résistance, et la détermination selon laquelle une condition de court-circuit de batterie est satisfaite sont effectuées sur la base de la satisfaction de la condition d'entrée.

8. Procédé selon l'une quelconque des revendications 1 à 7, dans lequel la valeur seuil de court-circuit est déterminée sur la base d'un résultat expérimental préliminaire, est déterminée sur la base d'un résultat réel de conduite pendant une section initiale de conduite de la batterie, ou est déterminée en ajustant un résultat expérimental existant au résultat réel de conduite.

9. Dispositif de détection de court-circuit, comprenant :
un ou plusieurs processeurs (801) ; et
une mémoire (802) stockant des instructions configurées pour, lorsqu'elles sont exécutées par le ou les processeurs (801), amener le ou les processeurs (801) à :
déterminer des données de mesure (101) en mesurant une batterie (110) pendant un intervalle de temps cible comprenant au moins un intervalle de temps de charge de la batterie (110) et un intervalle de temps de décharge de la batterie (110) ;
déterminer des données d'estimation (102) de la batterie (110) pour l'intervalle de temps cible au moyen d'un modèle de batterie (121) qui simule la batterie ;
déterminer (1030) un paramètre d'erreur de résistance de la batterie (110) sur la base d'une erreur entre les données de mesure (101) et les données d'estimation (102) ; et
détecter (1040) un court-circuit de la batterie (110) sur la base d'un résultat de comparaison entre le paramètre d'erreur de résistance et une valeur seuil de court-circuit,
**caractérisé en ce que**
le paramètre d'erreur de résistance comprend un premier sous-paramètre représentant une différence entre une première erreur de résistance moyenne dans un premier sous-intervalle de temps de l'intervalle de temps de décharge et une deuxième erreur de résistance moyenne dans un deuxième sous-intervalle de temps de l'intervalle de temps de charge.

10. Dispositif selon la revendication 9, dans lequel :
les données de mesure (101) comprennent une tension mesurée et un courant mesuré,
les données d'estimation (102) comprennent une tension estimée, et
le paramètre d'erreur de résistance est déterminé sur la base d'un rapport entre une erreur de tension et le courant mesuré, l'erreur de tension correspondant à une différence entre la tension mesurée et la tension estimée.

11. Dispositif selon la revendication 9 ou 10, dans lequel le paramètre d'erreur de résistance comprend en outre un ou plusieurs des éléments suivants :
un deuxième sous-paramètre représentant un taux de variation d'une erreur de résistance dans un troisième sous-intervalle de temps de l'intervalle de temps de décharge ; et
un troisième sous-paramètre représentant un taux de variation d'une erreur de résistance dans un quatrième sous-intervalle de temps de l'intervalle de temps de charge.

12. Dispositif selon l'une quelconque des revendications 9 à 11, dans lequel :
le paramètre d'erreur de résistance comprend des sous-paramètres présentant des degrés différents de sensibilité de détection à un court-circuit de la batterie (110), et
des mesures correctives différentes sont mises en œuvre en fonction des degrés de sensibilité de détection.

13. Dispositif selon l'une quelconque des revendications 9 à 12, dans lequel les instructions sont en outre configurées pour amener le ou les processeurs à :
déterminer une résistance interne de la batterie (110) sur la base d'une tension estimée des données d'estimation (102) et d'un courant mesuré des données de mesure (101) ;
déterminer un rapport d'erreur sur la base d'un rapport entre la résistance interne et le paramètre d'erreur de résistance ;
déterminer un courant de court-circuit sur la base d'une multiplication du courant mesuré et du rapport d'erreur ; et
déterminer une résistance de court-circuit sur la base d'un rapport entre la tension estimée et le courant de court-circuit.

14. Support d'enregistrement lisible par ordinateur non transitoire stockant des instructions qui, lorsqu'elles sont exécutées par un ou plusieurs processeurs d'un dispositif comprenant une batterie (110) configurée pour fournir de l'énergie au dispositif, amènent le ou les processeurs à :
mesurer des données de mesure (101) d'une batterie (110) pendant un intervalle de temps pendant lequel la batterie (110) est en cours de charge et est en cours de décharge ;
estimer des données d'estimation (102) de la batterie (110) sur la base d'une sortie d'un modèle de batterie (121) qui simule la batterie (110) ;
déterminer (1030) un paramètre d'erreur de résistance de la batterie (110) sur la base des données de mesure (101) et des données d'estimation (102) ; et
détecter (1040) un court-circuit de la batterie (110) sur la base du paramètre d'erreur de résistance et d'une valeur seuil de court-circuit,
**caractérisé en ce que**
le paramètre d'erreur de résistance comprend un premier sous-paramètre représentant une différence entre une première erreur de résistance moyenne dans un premier sous-intervalle de temps pendant lequel la batterie (110) est déchargée et une deuxième erreur de résistance moyenne dans un deuxième sous-intervalle de temps pendant lequel la batterie (110) est chargée.

15. Support d'enregistrement lisible par ordinateur selon la revendication 14, dans lequel les données de mesure (101) comprennent une tension mesurée et un courant mesuré, les données d'estimation (102) comprennent une tension estimée, et le paramètre d'erreur de résistance est déterminé sur la base d'un rapport entre une erreur de tension et le courant mesuré, l'erreur de tension correspondant à une différence entre la tension mesurée et la tension estimée, ou
dans lequel les données d'estimation (102) sont fournies par le modèle sur la base des données de mesure (101), et dans lequel le court-circuit est détecté sur la base d'une évaluation du paramètre d'erreur de résistance par rapport à une valeur seuil de court-circuit.
